Europäisches Patentamt

European Patent Office

Office européen des brevets

(19)

(11) Numéro de publication: **0 184 567**
**B1**

## FASCICULE DE BREVET EUROPEEN

(12)

(45) Date de publication du fascicule du brevet:
13.12.89

(51) Int. Cl.⁴: **G03F 7/26**, G03F 7/08

(21) Numéro de dépôt: 85870142.8

(22) Date de dépôt: 24.10.85

(54) Procédé de formation de motifs négatifs dans une couche de photorésist.

(30) Priorité: 26.10.84 GB 8427149

(43) Date de publication de la demande:
11.06.86 Bulletin 86/24

(45) Mention de la délivrance du brevet:
13.12.89 Bulletin 89/50

(84) Etats contractants désignés:
AT BE CH DE FR GB IT LI LU NL SE

(56) Documents cités:
EP-A- 0 017 032
EP-A- 0 038 967
EP-A- 0 091 651
EP-A- 0 136 130
EP-A- 0 161 476
WO-A-85/02030
GB-A- 2 097 143
JP-A- 5 961 928

EXTENDED ABSTRACTS,
vol. 82, no. 2, octobre 1982, pages 321,322, New Jersey,
US; D. FOLLETT et al.: "Polarity reversal of PMMA by
treatment with chlorosilanes"
IBM TECHNICAL DISCLOSURE BULLETIN,
vol. 20, no. 4, septembre 1977, page 1446, New York, US;
F.P. HOOD III et al.: "High resolution negative mode

(73) Titulaire: UCB Electronics, S.A., 326, Avenue Louise,
B-1050 Bruxelles(BE)

(72) Inventeur: Roland, Bruno, Waverse Baan, 120,
B-3030 Heverlee(BE)
Inventeur: Vrancken, August, Matenstraat 5A,
B-3600 Genk(BE)

(74) Mandataire: Dusseldorp, Raymond, U.C.B. S.A.
Département D.T.B. 326, avenue Louise, Bte 7,
B-1050 Bruxelles(BE)

(56) Documents cités: (suite)
electron-beam resist process"
JOURNAL OF THE ELECTROCHEMICAL SOCIETY,
vol. 131, no. 7, juillet 1984, pages 1664-1670, Manchester, New Hampshire, US; T.M. WOLF et al.: "The scope
and mechanism of new positive tone
gas-phase-functionalized plasma-developed resists"
PATENTS ABSTRACTS OF JAPAN,
vol. 6, no. 88 (P-118)[966], 26 mai 1982; & JP - A
- 57 23 937 (MATSUSHITA DENKI SANGYO
K.K.) 08.02.1982
EXTENDED ABSTRACTS,
vol. 83, no. 2, 1983, pages 331-332, Pennington, New
Jersey, US; WEN-TAO LIN et al.: "PMMA resist
sensitivity amplification by E-beam induced grafting of
acrylic acid"

## Description

La présente invention concerne un nouveau procédé microlithographique. Elle se rapporte plus particulièrement à un procédé de formation de motifs négatifs dans une couche de photorésist permettant la production à l'échelle industrielle avec un rendement élevé de microcircuits à très grande intégration (VLSI) dont la largeur des lignes peut descendre jusqu'en-dessous du micromètre. L'invention a également pour objet l'utilisation de ce nouveau procédé pour la fabrication de circuits semi-conducteurs intégrés.

La tendance actuelle vers la miniaturisation dans le domaine des circuits semi-conducteurs intégrés crée la nécessité d'adapter plus de circuits actifs par unité de surface sur la surface d'un cristal de semi-conducteur.

A titre d'exemple, on prendra en considération le développement commercial des dispositifs à mémoire à accès aléatoire (RAM) de semi- conducteur à grille isolée par oxyde métallique (MOS) évoluant de 1 Kbit en 1975 via 16 Kbits en 1977 et 64 Kbits en 1979 à 256 Kbits en 1982. On s'attend à ce que cette tendance se poursuive au cours des deux décennies suivantes. Par conséquent, on s'attend à ce que la dimension caractéristique minimale des dispositifs semi-conducteurs continue à décroître de 8 micromètres pour les dispositifs RAM MOS de 1 Kbit à 2 micromètres pour les dispositifs RAM MOS de 256 Kbits en 1982 jusqu'en-dessous de 1 micromètre avant la fin des années '80.

La fabrication de microcircuits requiert la diffusion sélective de petites quantités contrôlées d'impuretés dans des régions spécifiques de la surface du semi-conducteur pour produire les caractéristiques électriques désirées du circuit, telles que des éléments de transistor et d'autres éléments dont un circuit à très grande intégration contient plusieurs dizaines de milliers d'unités individuelles interconnectées de manière complexe par des conducteurs tels que de l'aluminium ou du silicium polycristallin fortement dopé.

La technique utilisée dans la production commerciale de circuits intégrés pour obtenir des motifs spécifiques est appelée photolithographie ou microlithographie. On recouvre le substrat de silicium (tranche), éventuellement oxydé, d'une couche de résine photosensible, également appelée photorésist, ou plus simplement résist, et on l'expose à travers un masque à de la lumière ultraviolette. Les propriétés chimiques et physiques des régions irradiées sont différentes des régions non irradiées et créent la possibilité d'enlever lors d'une étape de développement la partie exposée (dans une résine positive) ou la partie non exposée (dans une résine négative).

Les procédés de développement sont principalement basés sur des différences de solubilité et sont réalisés par une technique par voie humide. Après enlèvement d'une partie de la couche de résist, la surface dénudée du substrat peut être traitée (gravée, dopée, oxydée, traitée au nitrure, plaquée, etc.).

On répète ce procédé photolithographique (plus de dix fois) avant de réaliser les géométries de circuit tridimensionnelles nécessaires pour un dispositif de semi-conducteur à grille isolée par oxyde métallique (MOS) ou bipolaire. La structure d'un circuit intégré est complexe à la fois en ce qui concerne la topographie de sa surface et sa composition interne. Chaque élément de ce dispositif a une architecture tridimensionnelle complexe qui doit être reproduite exactement dans chaque circuit. La structure est constituée d'un grand nombre de couches, dont chacune est une image détaillée. Certaines des couches se situent à l'intérieur de la tranche de silicium et d'autres sont rassemblées en surface. Le procédé est décrit dans l'ouvrage de L.F. THOMPSON, C.G. WILLSON et M.J. BOWDEN "Introduction to Microlithography", American Chemical Society Symposium, Series 219, Amer. Chem. Soc., Washington, D.C., 1983.

Comme conséquence de la densité croissante des circuits à très grande intégration, la dimension minimale des caractéristiques des dispositifs semi-conducteurs diminue et les procédés de fabrication deviennent plus difficiles. L'obtention d'une haute résolution avec un bon contrôle de la largeur des lignes sur des substrats présentant une topographie de surface est un sérieux problème. Par suite de réflexions optiques et de variations d'épaisseur du résist sur des gradins élevés, le contrôle de la largeur des lignes devient très difficile et des couches de résist relativement épaisses sont nécessaires. Etant donné que pour ces petites caractéristiques, les dimensions latérales se rétrécissent plus rapidement que les dimensions verticales, il faut des rapports d'aspect de la hauteur à la largeur plus élevés pour les images de résist. De plus, les techniques de gravure sèche requièrent des images de résist relativement épaisses et stables.

Toutefois, les couches épaisses de résist limitent la résolution et créent des problèmes de profondeur de champ pour l'impression par projection. En outre, le gonflement des résists négatifs dans les révélateurs à base de solvants organiques les rend inappropriés pour une microlithographie à haute résolution et limite le choix aux résists à action positive contenant des diazoquinones. Mais même ces résists à contraste élevé et à haute résolution deviennent insuffisants lorsque les largeurs des lignes diminuent vers les régions du micromètre et en-dessous du micromètre.

Plusieurs méthodes pour obtenir une résolution plus élevée et un meilleur contrôle de la largeur des lignes ont été développées au cours de ces dernières années. De nouvelles techniques d'exposition ont été étudiées, telles que l'impression par faisceaux d'électrons, l'exposition aux rayons X et aux rayons ultraviolets lointains. La lithographie par faisceaux d'électrons requiert un équipement très coûteux, elle présente en outre l'inconvénient d'un faible taux de production et ne permet pas de produire des rapports d'aspect élevés à cause de la rétrodiffusion d'électrons: effet que l'on appelle effet de proximité. L'exposition aux rayons X permet d'atteindre des résolutions très élevées mais l'équipement et les résists sont encore au stade préindustriel. En outre, la fabrication de masques pour la lithographie aux rayons X est une opération difficile. L'utilisation de lumière UV lointaine diminue les effets de diffraction, mais la résolution est encore limitée par le gonflement des résists négatifs, et des résists positifs pour l'UV lointain ayant une sensibilité suffisante, ne sont pas encore disponibles.

Pour remédier aux effets défavorables des solvants au cours du développement par voie humide, on a déjà envisagé de développer les photorésists par plasma (cf. J.N. SMITH, H.G. HUGHES, J.V. KELLER, W.R. GOODNER et T.E. WOOD, dans Semiconductor International, 2, (1979, n°10, Décembre), p.41-47. Le développement par voie sèche des résists constitue un pas important vers un procédé de microfabrication totalement sec, offrant un contrôle opérationnel, une reproductibilité et une propreté meilleurs. De plus, le développement par voie sèche résout des problèmes tels que la perte de résolution par gonflement (en particulier dans le cas des résists négatifs) et la manipulation de grandes quantités de solvants inorganiques ou organiques. Il présente également une bien meilleure adaptabilité aux procédés de fabrication en chaîne automatique. Toutefois, la plupart des systèmes de résist destinés au développement par voie sèche ont un faible contraste et subissent une diminution importante de leur épaisseur au cours du développement.

Un autre moyen pour obtenir une haute résolution et un rapport d'aspect élevé est d'utiliser des systèmes de résist à couches multiples. Dans ces procédés, un excellent recouvrement des gradins et une excellente résistance à la gravure sèche d'une couche inférieure aplanissante épaisse sont combinés avec la haute résolution d'une mince couche supérieure de formation d'images. Les deux couches peuvent être optimisées en ce qui concerne leurs exigences spécifiques. Après exposition et développement de la mince couche supérieure de résist, les motifs obtenus sont transférés presque verticalement dans l'épaisse couche sous-jacente, soit par exposition à un rayonnement ultraviolet lointain et développement, soit par gravure par ions réactifs d'oxygène. Pour cette dernière méthode, une troisième couche intermédiaire est intercalée entre la couche de formation d'images et la couche aplanissante. Habituellement, on fait appel à une couche d'oxyde de silicium appliquée par centrifugation ou déposée par plasma sur la surface de la couche aplanissante. Les images exposées et développées dans la couche supérieure de résist sont transférées dans la couche intermédiaire (oxyde de silicium) par des techniques de gravure sèche. Après enlèvement de la couche de résist, les motifs très fins d'oxyde de silicium servent de masque très efficace pour la gravure par ions réactifs d'oxygène de la couche inférieure épaisse, conduisant à des profils avec des parois latérales presque verticales. On a utilisé également comme couche intermédiaire de l'aluminium ou du nitrure de silicium.

Avec ces techniques, on peut obtenir une haute résolution et des rapports d'aspect élevés sur des substrats présentant une topographie de surface (cf. J.M. MORAN et D. MAYDAN dans The Bell System Technical Journal, 58, (1979, n°5, mai-juin, p.1027-1036).

Les systèmes de résist multicouches présentent cependant également un certain nombre d'inconvénients. Ainsi, il se forme des couches interfaciales lorsque l'on applique par centrifugation une matière polymère sur une autre. Des étapes de cuisson intense peuvent réduire quelque peu ce phénomène mais, même dans ce cas, des traitements supplémentaires sont nécessaires pour enlever ces couches avant le transfert des motifs. La cuisson peut cependant provoquer des tensions sur le film. Les films d'oxyde de silicium appliqués par centrifugation sont très susceptibles de se fissurer lorsque la température de cuisson est trop élevée. D'un autre côté, une température de cuisson suffisamment élevée est nécessaire pour éviter un mélange interfacial entre l'oxyde et la couche de formation d'images.

Un autre problème réside dans les effets d'interférence optique. Même avec une couche inférieure fortement absorbante, des réflexions peuvent se produire aux interfaces conduisant à des ondes stationnaires. Une cuisson post-exposition de la couche de formation d'images peut réduire ces effets, mais uniquement aux dépens d'une perte de contraste.

Finalement, les minces couches supérieures de résist que l'on utilise dans les systèmes multicouches pour produire de meilleures images rendent le système plus sensible aux problèmes de formation de piqûres. Des systèmes de résist multicouches sont décrits en détail par B.J. LIN dans l'ouvrage "Introduction to Microlithography", dont question ci-dessus, p.287-350.

Un autre inconvénient majeur des systèmes multicouches est la complexité du procédé. Plusieurs couches doivent être appliquées et cuites, et chacune d'entre elles doit être exposée, développée et/ou gravée. C'est pourquoi des efforts ont récemment été faits pour simplifier ces systèmes multicouches, sans pour autant perdre leurs avantages. Un exemple est le procédé de gravure par ions réactifs (RIE) à deux couches, dans lequel la couche supérieure de formation d'images est un résist contenant des composants à la fois organique et inorganique, comme par exemple du poly(diméthyl siloxane) et du poly(vinyl-méthyl siloxane) (cf. M. HATZAKIS et coll. dans Proceedings of the International Conference on Microlithography, 1981, p.386-396), des copolymères de chlorométhylstyrène et de triméthylsilylstyrène (cf. M. SUZUKI et coll., dans J. Electrochem. Soc. 130, (1983), p. 1962-1964 et des copolymères de vinyltriméthylsilane et de dioxyde de soufre (brevet américain 4.357.369). La mince couche supérieure de résist est exposée et développée, suivi d'une gravure de l'épaisse couche inférieure par ions réactifs d'oxygène. Au cours de ce procédé, les composants inorganiques dans le résist forment des oxydes réfractaires qui agissent à la manière d'un masque de gravure formé in situ. De cette manière, la couche supérieure de formation d'images et la couche intermédiaire d'oxyde de silicium du système de résist à trois couches, sont combinées en une seule couche de résist organométallique. Le traitement de ces systèmes est plus facile que ceux à trois couches mais encore toujours plus complexe que les systèmes à une seule couche.

Jusqu'à présent, ils n'ont été mis au point que pour l'exposition aux faisceaux d'électrons et à l'UV lointain, et ils requièrent encore toujours un développement par voie humide dans des solvants organiques. Un autre exemple de système multicouches simplifié réside dans l'emploi d'une couche permettant d'augmenter le contraste. Dans ce procédé, une mince couche photoblanchissable est appliquée sur un photorésist positif standard. Au cours de l'exposition, le colorant dans la couche ainsi appliquée se décolore, en formant un nouveau masque en contact intime avec la surface du résist. Après exposition, on enlève la couche dans un système solvant et on traite le résist ensuite par des techniques conventionnelles. Bien que ce procédé améliore le contraste et n'augmente que légèrement la complexité du procédé, il ne résout pas le problème des ondes stationnaires et des variations de la largeur des lignes sur les gradins. De plus, il faut des temps d'exposition prolongés.

L'idéal serait évidemment de pouvoir disposer d'un système de résist à une seule couche offrant les mêmes avantages techniques que les systèmes de résist multicouches, mais ne présentant pas leurs inconvénients. De cette manière, on supprimerait la formation de couches interfaciales, les effets d'interférence optique et les problèmes des tensions sur le film et on réduirait drastiquement la complexité du procédé.

Mais la difficulté est de trouver un système de résist à une seule couche, qui peut être développé par voie sèche et qui se caractérise en même temps par une haute résolution, des rapports d'aspects élevés et un excellent contrôle de la largeur des lignes sur des substrats présentant une topographie de surface, de manière à obtenir des motifs de résist d'excellente qualité permettant la fabrication avec une bonne reproductibilité de circuits semiconducteurs à très grande intégration.

C'est pourquoi différentes tentatives ont été faites pour améliorer les systèmes de résist à une seule couche. Ainsi, par exemple, dans la demande de brevet japonais 23937/82, on décrit un procédé dans lequel un photorésist positif, appliqué sur un substrat, est exposé à une atmosphère contenant un composé organique de silicium, plus particulièrement l'hexaméthyldisilazane. Après exposition à la lumière ultraviolette, on développe le photorésist de manière conventionnelle en dissolvant les parties irradiées avec un révélateur liquide alcalin. Le traitement avec les vapeurs d'hexaméthyldisilazane a pour effet de réduire la vitesse de développement du photorésist dans le révélateur alcalin, permettant ainsi d'obtenir des motifs de résist ayant un contraste plus élevé (bords plus verticaux).

A noter que, abstraction faite du traitement avec les vapeurs d'hexaméthyldisilazane, ce procédé ne se distingue en rien du procédé photolithographique conventionnel. La formation des images est encore toujours basée sur des différences de solubilité engendrées par la création de groupes carboxyliques dans le photorésist sous l'effet de la lumière ultraviolette et le développement se fait exclusivement par voie humide dans un révélateur alcalin. Bien que par ce procédé le contraste soit augmenté, les inconvénients bien connus du développement par voie humide ne sont pas supprimés. L'irradiation doit se faire en profondeur dans la couche de résist, ce qui a pour conséquence que des effets tels que des réflexions et des ondes stationnaires ne peuvent pas être supprimés. Ceci peut conduire à des variations de la largeur des lignes (surtout sur une topographie réfléchissante).

D. FOLLETT et al. ("Polarity reversal of PMMA by treatment with chlorosilanes" -The Electrochemical Society Extended Abstracts 82-2 (1982, Octobre 17-21), p.321-322), décrivent un procédé dans lequel une résine de poly(méthacrylate de méthyle) (désigné ci-après par PMMA) est irradiée par un faisceau d'électrons, ensuite successivement traitée par des vapeurs de dichlorodiméthylsilane et des vapeurs d'eau, pour former des polysiloxanes et, pour terminer, développée dans un plasma d'oxygène. Selon ces auteurs, il y aurait diffusion sélective du dichlorodiméthylsilane dans les parties irradiées et partiellement dégradées du résist, suivie d'une polymérisation du chlorosilane, sous l'effet de l'exposition à la vapeur d'eau. Ils constatent une inversion de la polarité du résist de positif en négatif: les régions irradiées et traitées du PMMA présentent en effet une résistance plus élevée au plasma d'oxygène. On obtient des motifs constitués de lignes de 2 micromètres de largeur, avec un espacement de 4 micromètres et des profils avec des bords abrupts. Ce procédé présente néanmoins plusieurs inconvénients importants. L'exposition par faisceaux d'électrons, bien qu'elle permette une haute résolution, requiert un appareillage très coûteux et les durées d'irradiation par tranche de silicium sont beaucoup trop longues. A cause de ces limitations, la lithographie par faisceaux d'électrons n'est utilisee à l'heure actuelle que pour l'écriture directe de motifs pour des dispositifs destinés à la recherche. En outre, le PMMA est un matériau qui offre une très faible résistance aux opérations de gravure sèche, parce qu'il se dégrade très vite dans les plasmas utilisés à cet effet (5 fois plus vite que les polymères aromatiques). Enfin, étant donné que le dichlorodiméthylsilane n'est pas fixé immédiatement aux parties irradiées de la couche de PMMA (puisqu'il faut de la vapeur d'eau pour la conversion en polysiloxanes), on peut concevoir que ce composé peut facilement ressortir de la couche par diffusion. Ceci aura nécessairement un effet préjudiciable sur la reproductibilité des caractéristiques des motifs obtenus, parce que la concentration du dichlorodiméthylsilane dans la couche sera fonction du temps qui s'écoule entre le traitement avec ce composé et le traitement avec la vapeur d'eau.

T.M. WOLF et coll. dans J.Electrochem. Soc. 131,(1984,n°7),p.1664-1670, proposent encore un autre procédé destiné à améliorer les systèmes de résist à une seule couche. Les photorésists employés par ces auteurs sont des photorésists négatifs conventionnellement utilisés en photolithographie. Ils sont constitués par du polyisoprène partiellement cyclisé contenant un bis-azide comme photosensibilisateur (WAYCOAT IC-43 et SELECTILUX N-60 du commerce). Le procédé proposé comporte une étape d'exposition par irradiation ultraviolette ou par faisceaux d'électrons, une étape de traitement avec un halogénure inorganique volatil, suivie d'une étape de développement par gravure par ions réactifs d'oxygène. Dans les expériences décrites, ces auteurs emploient comme halogénures inorganiques volatils, le tétrachlorure de silicium ($SiCl_4$), le tétrachlorure d'étain ($SnCl_4$) et le dichlorodiméthylsilane (($CH_3$)$_2SiCl_2$), parce que ces composés sont susceptibles de réagir avec les amines secondaires formées lors de la photolyse du résist. Ils espéraient en effet que cette réaction pourrait être mise à profit pour incorporer les halogénures inorganiques sélectivement dans les zones exposées du résist autorisant ainsi, lors de l'étape suivante de développement par gravure par ions réactifs d'oxygène, la formation par oxydation d'une épaisse couche de protection d'oxyde inorganique dans lesdites zones exposées. Ainsi, seules les zones non exposées du photorésist seraient enlevées sélectivement par la gravure par ions réactifs d'oxygène.

Toutefois, ils constatent que les composés inorganiques sont absorbés rapidement, non seulement dans les zones exposées, mais également dans les zones non exposées du résist.

En outre, ils observent que, contre toute attente, par gravure par ions réactifs d'oxygène, les zones non exposées du photorésist sont protégées par une couche d'oxyde et gravées à une vitesse beaucoup plus faible que les zones exposées, tandis que les zones exposées sont enlevées sélectivement au cours de l'étape de développement par gravure sèche. Autrement dit, le photorésist se comporte comme un résist de type positif. Les auteurs expliquent ce phénomène par le fait qu'il se forme aussi dans les zones non exposées des complexes entre l'halogénure inorganique et le groupe azide du photosensibilisateur pendant que dans les zones exposées, il se produit la réaction prévue avec les produits de photolyse du résist. En outre, dans les zones non exposées, les complexes formés sont rapidement hydrolysés par la vapeur d'eau présente dans l'atmosphère ambiante et transformés en oxydes inorganiques réfractaires pendant l'opération de gravure par ions réactifs d'oxygène, formant ainsi une couche de protection in situ, alors que les produits de réaction formés dans les zones exposées sont moins rapidement hydrolysés et dès lors rapidement éliminés sous forme de composés volatils pendant l'opération de gravure par ions réactifs d'oxygène.

Il y a lieu de noter cependant que ce procédé présente encore des inconvénients importants.

En premier lieu, d'après les propres explications des auteurs, ce procédé ne donne satisfaction qu'à condition de respecter des durées très strictes d'exposition à la lumière et en même temps des durées très strictes de traitement avec l'halogénure inorganique. En effet, pour obtenir un résultat satisfaisant, il est nécessaire que l'exposition à la lumière du photorésist se fasse pendant 16 secondes et que le traitement avec l'halogénure inorganique se fasse pendant 7 secondes. Des durées d'exposition et/ou de traitement plus courtes ou plus longues fournissent des résultats peu satisfaisants. Ainsi, par exemple, après un traitement avec l'halogénure inorganique pendant 10 secondes, il n'est plus possible de développer le résist par gravure et ce quelle que soit la durée d'exposition à la lumière. En d'autres termes, les conditions opératoires sont très critiques, ce qui ne peut qu'être préjudiciable pour la reproductibilité des résultats.

En second lieu, même dans les conditions optimales citées ci-dessus, il subsiste après développement par gravure sèche, 70% seulement de l'épaisseur initiale du photorésist.

En troisième lieu, comme le montre la figure 11 à la page 1669 de l'article, il reste après développement, dans les zones dénudées, un résidu important qu'il est très difficile d'éliminer (ceci démontre en même temps que la sélectivité du procédé est insuffisante).

En conclusion, on voit donc que jusqu'à présent on n'est pas encore parvenu à mettre au point un procédé microlithographique dans lequel on utilise un système de résist à une seule couche qui donne entière satisfaction.

C'est pourquoi la demanderesse a effectué des travaux de recherche pour mettre au point un procédé microlithographique à une seule couche qui ne présenterait plus les inconvénients des procédés actuellement connus, en particulier de ceux décrits dans la demande de brevet japonais 23937/82 et dans les articles précités de D. FOLLET et al. et de T.M. WOLF et coll. Cet objectif est atteint pleinement avec le procédé décrit ci-après qui possède tous les avantages et la simplicité de la microlithographie à une seule couche, autorise l'usage des techniques de gravure sèche et qui peut être utilisé sur un équipement courant d'impression par projection et sur des appareils de déplacement de tranches pas-à-pas, tout en produisant une résolution en dessous du micromètre au moins égale, voire supérieure à celle des procédés multicouches susmentionnés.

La présente invention a donc pour objet un nouveau procédé microlithographique plus perfectionné. De façon plus spécifique, la présente invention procure un procédé de formation de motifs négatifs dans une couche de photorésist caractérisé en ce qu'il comprend les stades suivants:

(a) le recouvrement d'un substrat par une couche de résine photosensible comprenant un polymère contenant des groupes fonctionnels capables de réagir avec un composé de silicium, ledit polymère étant mélangé ou attaché par une liaison chimique à une diazoquinone, ladite couche ayant la propriété de permettre à un composé de silicium de diffuser sélectivement dans ses parties irradiées lorsqu'elle a été exposée à un rayonnement visible ou ultraviolet dans lesdites parties;

(b) l'exposition à de la lumière ultraviolette ou visible de la couche de résine photosensible à travers un masque, de façon à ce que seules les parties voulues de la couche soient exposées;

(c) le traitement de la couche de résine photosensible par un composé de silicium, de manière à ce que ce composé soit sélectivement absorbé dans les parties irradiées de la couche et entre en réaction avec lesdits groupes fonctionnels de la résine photosensible dans ces parties irradiées, ledit composé de silicium étant un agent de silylation; et

(d) le développement par voie sèche par gravure au plasma de la couche de résine photosensible ainsi traité, de manière à enlever sélectivement les parties non irradiées de celle-ci pour obtenir les motifs négatifs souhaités.

Selon une forme de réalisation préférée de l'invention, le substrat est une plaquette de silicium, la résine photosensible utilisée comprend un polymère phénolique et le composé de silicium est un agent de silylation facilement vaporisable.

Selon une forme particulièrement préférée de l'invention, le polymère phénolique est lié chimiquement à la diazoquinone.

Par ailleurs, selon la présente invention, le traitement par le composé de silicium est, de préférence, exécuté après l'exposition de la couche de résine photosensible à la lumière ultraviolette ou visible. Toutefois, l'homme de métier comprendra que, dans un but de simplicité et de rapidité d'exécution, il est possible d'effectuer le traitement par le composé de silicium déjà au cours de l'exposition à la lumière de la couche de résine photosensible. Autrement dit, il est possible d'exécuter les stades (b) et (c) du procédé simultanément.

Suivant une forme de réalisation particulièrement préférée, le composé de silicium est volatilisé et mis en contact sous forme de vapeurs avec la couche de résine photosensible.

Selon une forme de réalisation particulièrement avantageuse de l'invention, le développement par voie sèche est effectué par gravure au plasma d'oxygène ou par ions réactifs d'oxygène.

L'invention comprend en outre l'utilisation du nouveau procédé microlithographique pour la fabrication de circuits semi-conducteurs intégrés.

Le procédé conforme à l'invention repose sur la découverte surprenante que les résines photosensibles à action positive, mettant en jeu un polymère phénolique associé à une diazoquinone en tant que composé photosensible, subissent des modifications substantielles de leurs propriétés sous l'influence d'un rayonnement visible ou ultraviolet. La demanderesse a observé, en effet, que l'exposition au rayonnement modifie sensiblement les propriétés de perméabilité de ces résines et elle a mis à profit cette particularité pour mieux différencier les parties irradiées des parties non irradiées d'une couche de ces résines déposée sur un substrat et, par voie de conséquence, mettre au point un procédé microlithographique à une seule couche beaucoup plus perfectionné. Dans ce but, conformément à l'invention, la couche de résine photosensible irradiée est soumise à un traitement par un composé de silicium afin que, grâce à la particularité qui vient d'être évoquée ci- dessus, ce composé puisse pénétrer sélectivement dans les parties irradiées de la couche, de préférence dans la partie supérieure de celle-ci, et se fixer préférentiellement dans ces parties irradiées en entrant en réaction avec les groupes fonctionnels de la résine photosensible.

L'expérience a montré qu'effectivement les composés de silicium diffusent sélectivement dans les parties irradiées de la couche, alors qu'une telle diffusion ne se produit pratiquement pas dans les parties non irradiées, ou seulement de façon insignifiante.

A la différence donc du procédé de T.M. WOLF et coll., décrit plus haut, les composés de silicium ne diffusent pas dans toutes les parties de la couche du photorésist, mais uniquement dans les parties irradiées de cette couche.

Le procédé de l'invention repose donc sur une diffusion sélective des composés de silicium dans les parties irradiées du photorésist, à la différence du procédé de l'état de la technique qui repose exclusivement sur une réaction sélective des composés de silicium dans les parties irradiées ou non irradiées (les composés de silicium étant incorporés dans toutes les parties du photorésist).

Du point de vue technique, cette différence a des répercussions considérables sur les résultats parce que, dans le procédé conforme à l'invention, après développement par gravure sèche par plasma, on obtient des motifs de qualité supérieure. En outre, on supprime définitivement les inconvénients rappelés plus haut des procédés connus à une seule couche. Par gravure sèche, les parties non irradiées du photorésist sont complètement éliminées et, dans les parties irradiées, il se forme très rapidement un masque d'oxyde de silicium in situ qui subsiste et protège très efficacement ces parties pendant toute l'opération de gravure.

Après développement, l'épaisseur des motifs obtenus est pratiquement identique à l'épaisseur initiale du photorésist; l'épaisseur résiduelle représente en général plus de 95% de l'épaisseur initiale de la couche de résine déposée sur le substrat. Dans les zones dénudées, il ne subsiste aucun résidu. En outre, la reproductibilité est considérablement améliorée parce que les durées d'exposition à la lumière et les durées du traitement par le composé de silicium n'ont pratiquement pas d'incidence sur les résultats (contrairement au procédé de T.M. WOLF et coll. décrit plus haut).

Ainsi, la présente invention procure un système de résist à une seule couche qui peut être développé par voie sèche et qui possède tous les avantages des résists multicouches: aplanissement, haute résolution, des rapports d'aspect élevés avec une excellente rétention de l'épaisseur initiale de la couche de résine photosensible déposée sur le substrat, un bon contrôle de la largeur des lignes sur les gradins, une bonne reproductibilité des caractéristiques des motifs et la suppression de l'interférence avec la lumière réfléchie sur la topographie du substrat. De plus, le système décrit comporte plusieurs avantages par rapport aux systèmes de résist multicouches. Il ne se forme pas de couches interfaciales, il ne se produit pas d'interférence avec la lumière réfléchie, les problèmes des tensions sur le film n'existent pas et la complexité du procédé est réduite d'une manière draconienne.

Bien que le procédé de l'invention fournisse un système de résist à action négative, il ne nécessite pas de développement par voie humide, ce qui supprime définitivement les problèmes de perte de résolution par gonflement dans les solvants de révélation. De plus, étant donné l'absence de solvants dans le stade de développement, l'adhérence n'est plus un paramètre critique. Le traitement totalement à sec du résist conduit à un contrôle amélioré du procédé et rend ce système particulièrement approprié pour les procédés de fabrication en chaîne automatique.

L'invention sera à présent décrite ci-après plus en détail en se référant au dessin d'accompagnement dans lequel les mêmes numéros de référence se réfèrent à des éléments similaires dans les différentes figures, les couches étant représentées à une échelle fortement exagérée.

La figure 1 est une vue en coupe transversale partielle d'une tranche de silicium recouverte d'une couche de résine photosensible avant le stade d'exposition.

La figure 2 est une vue en coupe transversale partielle d'une tranche de silicium recouverte d'une couche de résine photosensible au cours de son exposition à la lumière à travers un masque.

La figure 3 est une vue en coupe transversale partielle d'une tranche de silicium recouverte d'une couche de résine photosensible, après le traitement avec le composé de silicium.

La figure 4 est une vue en coupe transversale partielle des motifs négatifs obtenus après développement par gravure par ions réactifs d'oxygène ou par plasma d'oxygène.

Une large gamme de polymères peut être utilisée pour préparer la résine photosensible utilisée dans le procédé conforme à l'invention.

Toutefois, de préférence, on utilise un polymère phénolique choisi parmi:

— les produits de condensation d'un phénol, d'un naphtol ou d'un dérivé de ceux-ci, substitué sur le noyau par un radical alkyle ou aryle ou par un atome d'halogène, avec un aldéhyde aliphatique ou aromatique, substitué ou non par un atome d'halogène,
— les poly(vinylphénols) dont le groupe phénolique est substitué ou non par un radical alkyle ou aryle ou un atome d'halogène,
— les copolymères d'un vinylphénol avec des composés éthyléniquement insaturés, et
— les mélanges des polymères précités entre eux ou avec d'autres polymères aromatiques, tels que le polystyrène ou le poly(N-vinylcarbazole).

Comme exemples illustratifs mais non limitatifs de polymères phénoliques, on citera notamment: les phénols-novolaques, les crésols-novolaques, les produits de condensation de formaldéhyde avec des alkylphénols (p-tert-butylphénol; p-n-propylphénol; p-éthylphénol; octylphénol), les produits de condensation de benzaldéhyde avec des crésols ou des naphtols (par exemple le 1-naphtol); les poly(p-vinylphénols), les copolymères de p-vinylphénols avec du p-chlorostyrène.

Le composé photosensible mélangé ou lié chimiquement au polymère est une diazoquinone telle qu'on en utilise dans les photorésists positifs classiques (cf. brevet britannique 711 626). En tant qu'exemples non limitatifs de ces diazoquinones, on citera notamment:

l'acide 5-diazo-5,6-dihydro-6-oxo-1-naphtalènesulfonique, l'acide 6-diazo-5,6- dihydro-5-oxo-1-naphtalènesulfonique, l'acide 3-diazo-3,4-dihydro-4-oxo-1-naphtalènesulfonique, l'acide 4-diazo-3,4-dihydro-3-oxo-1-naphtalènesulfonique, l'acide 3-diazo-3,4-dihydro-4-oxo-1-benzènesulfonique, les acides carboxyliques correspondants, leurs dérivés et les mélanges d'au moins deux des composés précités.

Comme exemple d'un dérivé des acides précités, on peut citer le produit de condensation de 3 moles de chlorure de 6-diazo-5,6-dihydro-5-oxo-1- naphtalènesulfonyle avec 1 mole de 2,3,4-trihydroxybenzophénone.

Les composés photosensibles tels que les diazoquinones peuvent aisément être liés chimiquement aux polymères décrits ci-dessus par des procédés de synthèse conventionnels (cf. brevet américain n° 3.046.119); une réaction caractéristique bien connue est celle des dérivés de ces composés photosensibles comportant un substituant chlorure de sulfonyle (ou chlorure de carbonyle) avec les groupements hydroxyle des polymères phénoliques, pour former des sulfonates (ou des carboxylates).

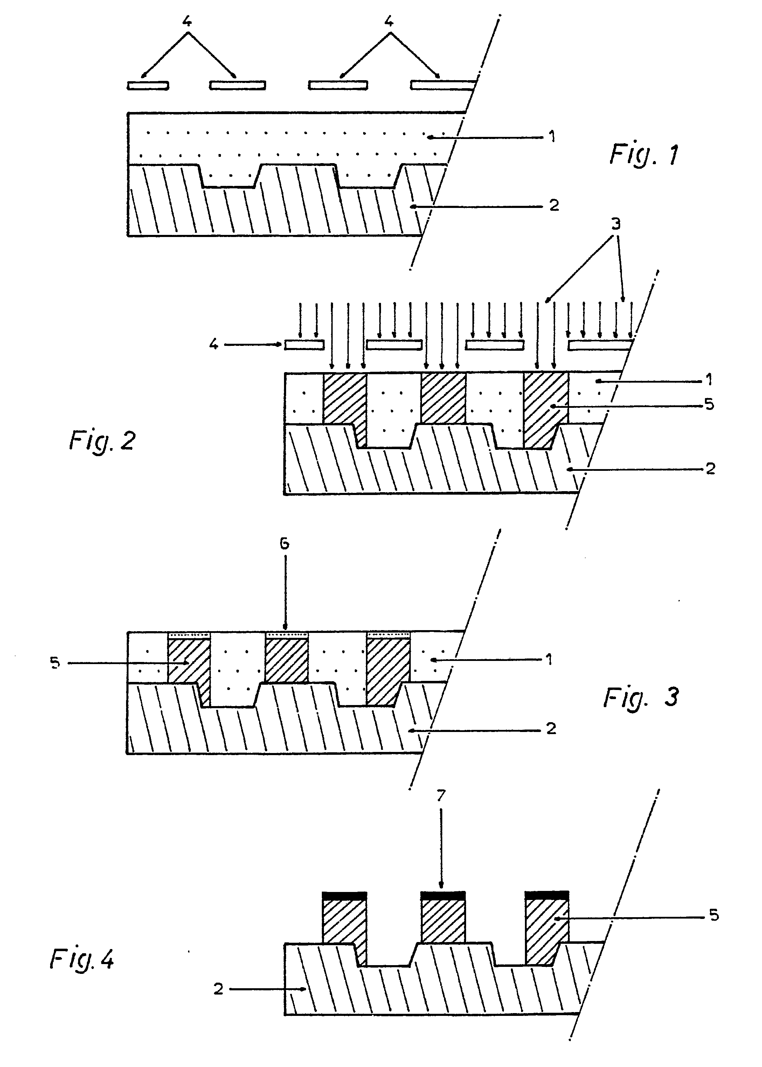

Ainsi qu'on le montre dans la figure 1, dans le premier stade du procédé de l'invention, une épaisse couche de résine photosensible (1) est appliquée sur une tranche de silicium ou substrat (2). Ce dépôt est en général effectué par enduction par centrifugation et à partir d'une solution diluée de la résine photosensible dans un solvant approprié. L'épaisseur de la couche de résine photosensible peut varier en fonction de la topographie du substrat. La présence du polymère dans la résine photosensible facilite la formation de surfaces bien égalisées et lisses sur le substrat.

Lorsque la résine photosensible est appliquée sur le substrat à partir d'une solution diluée dans un solvant, le solvant peut être choisi parmi une gamme étendue de produits dépendant des paramètres de solubilité, de la vitesse d'évaporation aux températures de traitement et des caractéristiques rhéologiques souhaitées. Des exemples de solvants pouvant être employés sont les suivants: cétones, esters, tels qu'acétates, propionates, etc..., éthers, éther esters, polyéthers, alcools, hydrocarbures aliphatiques ou aromatiques, tétrahydrofuranne, diméthylformamide, pyrolidones, etc. La nature du solvant est sans rapport avec l'objet de la présente invention pour autant que l'on obtienne une solution ayant des propriétés filmogènes. La concentration de la solution dépend de l'épaisseur souhaitée de la couche de résine photosensible.

Après avoir été appliquée sur le substrat, la couche de résine photosensible (1) est en général séchée par cuisson pour éliminer le solvant. Les conditions utilisées pendant cette étape de cuisson ne sont pas critiques pour autant que le solvant soit efficacement éliminé et que l'on obtienne une surface exempte de collant. En pratique, on utilise des températures d'environ 50° à environ 150°C et, de préférence, d'environ 80 à 120°C. Le temps de cuisson peut être diminué lorsque la température de cuisson est augmentée. Ce temps dépendra également de la facilité d'évaporation du solvant ou du mélange de solvants utilisé. Le temps de cuisson utilisé varie en pratique entre quelques secondes et 1 heure. Après cuisson, l'épaisseur de la couche de résine photosensible (1) est généralement comprise dans l'intervalle de 1 à 2,5 micromètres.

Ainsi qu'on le montre à la figure 2, le substrat (2) recouvert de la couche de résine photosensible (1) est ensuite exposé à un rayonnement visible ou ultraviolet (3) à travers un masque formateur d'images (4). La longueur d'onde du rayonnement appliqué est comprise entre 100 et 600 nm, de préférence entre 350 et 450 nm. Sous l'effet du rayonnement visible ou ultraviolet, les propriétés chimiques et physiques des parties irradiées (5) de la couche de résine photosensible subissent des modifications considérables par rapport aux parties non irradiées.

Bien que les mécanismes des réactions et/ou décompositions provoquées par l'exposition à la lumière visible ou ultraviolette ne soient pas encore tout à fait élucidés, il est bien connu que, lorsque le composé photosensible est une diazoquinone, de l'azote est éliminé et il se forme un acide indènecarboxylique en présence d'eau. Toutefois, comme indiqué précédemment, il se produit simultanément une modification très substantielle des propriétés de perméabilité de la couche de résine photosensible.

L'énergie du rayonnement visible ou ultraviolet peut être réglée de manière à provoquer cette modification de la perméabilité dans la couche de résine photosensible à la profondeur souhaitée. Selon une forme de réalisation préférée du procédé de l'invention, on provoque cette modification uniquement dans la partie supérieure, près de la surface de la couche.

Typiquement, mais de manière non limitative, l'énergie du rayonnement appliquée peut varier entre 10 et 130 millijoules par centimètre carré, mesurée à une longueur d'onde de 400 nanomètres; la quantité d'énergie à appliquer dépend évidemment de la nature de la résine photosensible et du composé de silicium utilisés dans le stade suivant du procédé.

L'absorption de la lumière par la couche de résine photosensible peut éventuellement être accrue par l'addition de colorants spécifiques, comme décrit par M.M. O'TOOLE, E.D. LIU et M.S. CHANG dans Proc.SPIE Int.Soc.Opt. Eng.,275,(1981) (Semicond.Microlithogr.VI), p.128-135 et par M. CHEN et coll. dans le brevet américain 4.362.809. Ces colorants doivent absorber d'une façon significative aux longueurs d'onde utilisées pour exposer la résine photosensible (100 à 600 nanomètres, de préférence 350-450 nanomètres), mais ils doivent être transparents dans une partie de la région visible pour rendre l'alignement possible au cours de l'exposition. Une concentration appropriée d'un tel colorant limitera l'exposition à une mince couche supérieure de la résine photosensible. On peut également ajouter des photosensibilisateurs ou d'autres agents similaires à la résine photosensible.

Comme il a déjà été expliqué plus haut, le traitement de la couche de résine photosensible par le composé de silicium peut être effectué pendant l'exposition à la lumière, mais de préférence après cette exposition, pour de simples raisons de facilité de manipulation. En outre, ce traitement peut être réalisé en phase liquide ou en phase vapeur. Selon une forme préférée de réalisation de l'invention, ce traitement est réalisé en phase vapeur. Ce dernier procédé est préféré parce qu'il permet l'utilisation de composés de silicium et plus particulièrement d'agents de silylation aisément vaporisables à des températures et des pressions appropriées.

A titre d'exemples non limitatifs de composés de silicium utilisables, on peut citer les agents de silylation suivants:
le tétrachlorosilane et les alkyl- et arylhalosilanes (par exemple le triméthylchlorosilane, le diméthyldichlorosilane, le méthyltrichlorosilane, le trimethylbromosilane, le triméthyliodosilane et le triphénylchlorosilane), les disilazanes (par exemple l'hexaméthyldisilazane, l'heptaméthyldisilazane, l'hexaphényldisilazane, le 1,3-bis(chlorométhyl)-1,1,3,3-tétraméthyldisilazane), le N-triméthylsilylimidazole, le N-triméthylsilylacétamide, la N- triméthylsilyldiméthylamine, la N-triméthylsilyldiéthylamine, l'hexaméthylsilanediamine, le N,O-bis(triéthylsilyl)acétimide, la N,N'- bis(triméthylsilyl)urée, la N,N'-diphényl-N-(triméthylsilyl)urée et les mélanges d'au moins deux de ces composés.

Le traitement de la couche de résine photosensible par le composé de silicium peut être effectué dans une chambre de réaction séparée ou dans un équipement de déplacement de tranches pas-à-pas.

Le traitement par le composé de silicium produit, comme déjà indiqué précédemment, la diffusion sélective du composé de silicium dans les parties irradiées (5) de la couche; ce composé se fixe ensuite dans ces parties en réagissant avec les groupes fonctionnels de la résine. Par contre, dans les parties non irradiées, on ne constate pratiquement pas de diffusion du composé de silicium ou uniquement de manière insignifiante en surface. L'incorporation du composé de silicium se fait donc uniquement dans les parties irradiées de la couche et non dans les parties non irradiées de celle-ci. Ce fait a pu être confirmé par une analyse par spectroscopie Auger (voir exemple 12).

Comme le montre la figure 3, l'incorporation du composé de silicium peut avantageusement être limitée à la partie supérieure (6) des parties irradiées (5) de la couche de résine photosensible.

L'épaisseur de la couche contenant du silicium est régie par les lois de diffusion et variera en fonction de la nature du composé de silicium et de sa concentration et de la composition de la résine photosensible. Pour un système donné, elle dépendra de la dose d'irradiation, de la durée, de la température et de la pression du traitement et, par conséquent, elle peut être orientée dans le sens voulu par des paramètres aisément contrôlables.

Etant donné que la formation des images peut se produire dans une couche plane très mince à la partie supérieure du photorésist, on peut obtenir des images de qualité par une impression par projection classique avec de la lumière étroitement focalisée.

Il suffira, en effet, de limiter l'exposition à la lumière UV à une mince couche à la partie supérieure de la résine photosensible, de manière à ce que la lumière soit suffisamment éteinte par absorption dans la partie restante de la couche avant qu'il ne se produise une interférence de lumière réfléchie. Il en résulte que les problèmes, tels que les ondes stationnaires et les variations de la largeur des lignes sur des gradins fortement réfléchissants, comme par exemple des interconnecteurs métalliques, sont éliminés.

Le traitement de la couche de résine photosensible par le composé de silicium est effectué à une température appropriée qui dépend de la nature de la résine et du composé de silicium utilisé; cette température est choisie de manière à ce qu'une diffusion sélective du composé de silicium ait lieu dans les parties irradiées de la résine; elle peut être choisie entre la température de vaporisation du composé de silicium (qui dépend elle-même de la pression régnant dans le système qui peut aller d'un vide relatif à plusieurs bars) et la température de décomposition thermique des constituants de la résine photosensible. En pratique, la température de ce traitement peut varier entre -20 et 150°C, et de préférence entre 60 et 140°C.

La durée du traitement par le composé de silicium n'est pas critique; elle dépend essentiellement de la température, et accessoirement de la nature de la résine photosensible et du composé de silicium. En pratique, cette durée peut varier entre quelques secondes et une heure, et de préférence entre 1 et 45 minutes.

Après le traitement de la résine photosensible par le composé de silicium, on peut éliminer l'excès de ce dernier pour des raisons de facilité de manipulation ultérieure, cette élimination se fait de préférence par évaporation sous vide. Il n'est toutefois pas indispensable d'éliminer l'excès de composé de silicium, les qualités des motifs obtenus par le procédé de l'invention étant tout aussi bonnes sans élimination de l'excès de composé de silicium, qu'avec cette élimination; ceci s'explique par le fait que le composé de silicium ne diffuse pratiquement pas dans les parties non irradiées de la résine photosensible et que ces parties sont par conséquent facilement enlevées par le développement ultérieur par gravure sèche par plasma d'oxygène ou par ions réactifs d'oxygène.

Au dernier stade du procédé de l'invention, la couche de résine photosensible traitée comme décrit ci-dessus, est développée par voie sèche en utilisant, de préférence, une technique de gravure par plasma d'oxygène ou par ions réactifs d'oxygène. Ces techniques, de même que l'appareillage utilisé pour leur mise en oeuvre, sont bien connus de l'homme de métier et il n'est pas nécessaire de les décrire en détail.

Ainsi qu'on le montre à la figure 4, le développement par gravure sèche a pour conséquence que les parties non irradiées du photorésist sont rapidement enlevées, tandis que les parties irradiées (5) résistent parfaitement grâce à la formation in situ d'un masque d'oxyde de silicium (7).

Lorsque les parties non irradiées sont complètement éliminées jusqu'à la surface du substrat (2), on obtient des motifs négatifs d'excellente qualité. En effet, comme on le montre plus loin dans les exemples, ces motifs présentent des parois latérales verticales, une haute résolution, la largeur des lignes pouvant être de moins d'un demi-micromètre et leur espacement voisin du demi-micromètre; une rétention parfaite de l'épaisseur initiale de la couche de résine déposée, pas de variation mesurable dans la largeur des lignes sur les gradins et un rapport d'aspect élevé, avec des hauteurs pouvant dépasser 2 micromètres. De plus, on obtient des surfaces exemptes de résidus dans les zones dénudées.

Les exemples suivants illustrent l'invention sans toutefois la limiter. Dans ces exemples, les valeurs indiquées pour l'énergie du rayonnement UV sont déterminées à une longueur d'onde de 400 nanomètres.

## Exemple 1.

Des tranches de silicium recouvertes d'un oxyde thermique d'environ 120 nanomètres d'épaisseur sont traitées par de l'hexaméthyldisilazane comme promoteur d'adhésion.

En tant que résine photosensible, on utilise le produit d'estérification partielle du chlorure de 6-diazo-5,6-dihydro-5-oxo-1-naphtalènesulfonyle avec le produit de condensation de p-tert-butylphénol et de formaldéhyde. Cette résine est dissoute dans un mélange de solvants contenant 80% en poids de 2-éthoxyéthanol, 10% en poids de xylène et 10% en poids d'acétate de n-butyle, de façon à obtenir une solution à 25% en poids.

Cette solution est enduite par centrifugation sur les tranches de silicium à une vitesse de rotation de 3000 tours par minute. De cette manière, on obtient sur chaque tranche une couche de résine de 1,7 micromètre d'épaisseur.

Les tranches ainsi enduites sont cuites dans un four à convection à 90°C pendant 30 minutes. Puis, on les soumet à une exposition aux rayons ultraviolets, à travers un masque, dans un équipement conventionnel produisant de la lumière UV dont la longueur d'onde est comprise entre 350 et 440 nm; l'énergie du rayonnement est de 60 mJ/cm2.

On traite ensuite les tranches ainsi exposées avec des vapeurs d'hexaméthyldisilazane à 91°C pendant 4 minutes.

Après développement par gravure par ions réactifs d'oxygène, on obtient dans les parties exposées des motifs négatifs présentant des parois latérales verticales. De plus, l'épaisseur de ces motifs est pratiquement identique à l'épaisseur initiale de la couche de résine déposée sur chaque tranche.

## Exemple 2.

On opère comme à l'exemple 1, mais en utilisant une résine photosensible constituée par un mélange de 100 g d'une novolaque de crésol-formaldéhyde du commerce et de 25 g d'un produit de condensation de trois moles de chlorure de 6-diazo-5,6-dihydro-5-oxo-1-naphtalènesulfonyle avec une mole de 2,3,4- trihydroxybenzophénone. Ce mélange est dissous dans 250 g d'un mélange de solvants contenant 80% en poids de 2-éthoxyéthanol, 10% en poids de xylène et 10% en poids d'acétate de n-butyle. La couche de résine formée a une épaisseur de 1,4 micromètre. Après précuisson, elle est exposée aux rayons UV, à travers un masque en appliquant une énergie de rayonnement de 70 mJ/cm², puis traitée par des vapeurs d'hexaméthyldisilazane pendant 30 minutes à 65°C. Après développement, on obtient des motifs négatifs présentant une épaisseur résiduelle de 1,2 micromètre, soit 86% de l'épaisseur initiale de la couche de résine déposée.

Exemple 3.

On opère comme à l'exemple 1, mais la résine photosensible utilisée est préparée par estérification partielle d'une novolaque de crésol-formaldéhyde du commerce avec le chlorure de 6-diazo-5,6-dihydro-5-oxo-1-naphtalènesulfonyle. 25 g de cette résine sont dissous dans 100 g d'acétate de 2-éthoxyéthyle. La couche de résine formée a une épaisseur de 1,5 micromètre. Après précuisson, elle est exposée aux rayons UV, à travers un masque, en appliquant une énergie de rayonnement de 85 mJ/cm², puis traitée par des vapeurs d'hexaméthyldisilazane pendant 10 minutes à 80°C. Après développement, on obtient des motifs négatifs ayant une épaisseur résiduelle de 1,4 micromètre, soit 93% de l'épaisseur initiale de la couche de résine déposée.

Exemple 4.

On procède comme à l'exemple 1, mais en utilisant une résine photosensible constituée par le produit d'estérification partielle du chlorure de 6-diazo-5,6-dihydro-5-oxo-1-naphtalènesulfonyle avec du poly(p-vinylphénol), 25 g de cette résine sont dissous dans 100 g d'acétate de 2- éthoxyéthyle. La couche de résine formée présente une épaisseur de 1,7 micromètre. Après précuisson, elle est exposée aux rayons UV, à travers un masque en appliquant une énergie de rayonnement de 85 mJ/cm², puis traitée par des vapeurs d'hexaméthyldisilazane pendant 3 minutes à 125°C. Les motifs négatifs obtenus après développement présentent des parois latérales verticales, ils ont une épaisseur résiduelle de 1,65 micromètre, soit 97% de l'épaisseur initiale de la couche de résine déposée.

Exemple 5.

Cet exemple montre que la présence du composé photosensible est indispensable pour obtenir une réaction sélective dans les parties irradiées de la couche du photorésist et il prouve de plus que le composé de silicium est susceptible de réagir avec le polymère phénolique.

On procède comme à l'exemple 1, mais on utilise une résine non photosensible constituée uniquement de poly(p-vinylphénol), c'est-à-dire sans le composé photosensible. 25 g de cette résine sont dissous dans 100 g d'acétate de 2-éthoxyéthyle et on enduit cette solution par centrifugation sur les tranches de silicium de façon à former une couche de résine de 1,7 micromètre d'épaisseur. Après précuisson, cette couche est exposée aux rayons UV à travers un masque, en appliquant une énergie de rayonnement de 130 mJ/cm². On traite ensuite les échantillons de deux manières différentes avec les vapeurs d'hexaméthyldisilazane:

a) à 130°C pendant 30 minutes. Dans ce cas, le développement par gravure par ions réactifs d'oxygène provoque l'enlèvement complet de la couche de résine, ne laissant aucun motif;

b) à 155°C pendant 10 minutes. Dans ce cas, la couche de résine résiste totalement à la gravure par ions réactifs d'oxygène. Aucune diminution perceptible de son épaisseur ne se produit, même après une opération de gravure prolongée. On n'obtient aucun motif.

Exemple 6.

On procède comme à l'exemple 1, sauf que la résine photosensible est remplacée par une résine préparée par estérification partielle d'un produit de condensation de p-n-propylphénol et de formaldéhyde, avec le chlorure de 6-diazo-5,6-dihydro-5-oxo-1-naphtalènesulfonyle. 30 g de cette résine sont dissous dans 100 g de 4-méthyl-2-pentanone. La couche de résine formée a une épaisseur de 2,3 micromètres. Après précuisson, elle est exposée aux rayons UV, à travers un masque en appliquant une énergie de rayonnement de 85 mJ/cm², puis traitée pendant 8 minutes à 115°C par des vapeurs d'hexaméthyldisilazane.

Le développement fournit des motifs négatifs à haute résolution (lignes de 0,45 micromètre de largeur et espacées de 0,85 micromètre), avec des parois latérales verticales; ils ont une épaisseur résiduelle de 2,15 micromètres, soit environ 94% de l'épaisseur initiale de la couche de résine déposée.

Exemple 7.

On opère comme à l'exemple 1, mais en utilisant une résine photosensible constituée par un mélange de 10 g de polystyrène et de 20 g du produit d'estérification partielle du chlorure de 6-diazo-5,6-dihydro-5-oxo-1-naphtalènesulfonyle avec le produit de condensation de p-éthylphénol et de formaldéhyde. Ce mélange est dissous dans 100 g de cyclohexanone. On forme une couche de 1,8 micromètre d'épaisseur qui, après précuisson, est exposée aux rayons UV, à travers un masque en appliquant une énergie de rayonnement de 110 mJ/cm². Puis, cette couche est traitée par des vapeurs de triméthylchlorosilane pendant 10 minutes à 100°C. Après développement, on obtient des motifs négatifs à haute résolution présentant des parois latérales verticales et ayant une épaisseur résiduelle de 1,5 micromètre, soit environ 85% de l'épaisseur initiale de la couche de résine déposée.

Exemple 8.

On opère comme à l'exemple 1, mais en utilisant une résine photosensible constituée par le produit d'estérification partielle du chlorure de 6-diazo-5,6-dihydro-5-oxo-1-naphtalènesulfonyle avec le produit de condensation de crésols et de benzaldéhyde. 25 g de cette résine sont dissous dans 100 g de bis(2-méthoxyéthyl)éther. La couche de résine formée a une épaisseur de 1,7 micromètre. Après précuisson, elle est exposée aux rayons UV, à travers un masque, en appliquant une énergie de 90 mJ/cm², puis traitée pendant 8 minutes à 125°C par des vapeurs d'hexaméthyldisilazane. Après développement, on obtient des motifs négatifs à haute résolution, présentant des parois latérales verticales et ayant une épaisseur résiduelle de 1,6 micromètre, soit 94% de l'épaisseur initiale de la couche de résine déposée.

## Exemple 9.

On procède comme à l'exemple 1, mais en utilisant une résine photosensible constituée par un mélange de 3 g de poly(N-vinylcarbazole) et de 20 g du produit d'estérification partielle du chlorure de 6-diazo-5,6-dihydro-5-oxo-1-naphtalènesulfonyle avec le produit de condensation de 1- naphtol et de benzaldéhyde. Ce mélange est dissous dans 100 g de bis(2-méthoxyéthyl)éther. La couche de résine formée a une épaisseur de 1,8 micromètre. Après précuisson sur une plaque chauffante à 95°C pendant 45 secondes, cette couche est exposée aux rayons UV, à travers un masque, en appliquant une énergie de rayonnement de 115 mJ/cm², puis traitée pendant 10 minutes à 120°C par des vapeurs d'hexaméthyldisilazane. Après développement, on obtient des motifs négatifs à haute résolution, présentant des parois latérales verticales et ayant une épaisseur résiduelle de 1,65 micromètre, soit 92% de l'épaisseur initiale de la couche de résine déposée.

## Exemple 10.

On opère comme à l'exemple 1, mais en utilisant une résine photosensible préparée par estérification partielle d'un copolymère de p-vinylphénol et de p-chlorostyrène, avec le chlorure de 6-diazo-5,6-dihydro-5-oxo-1-naphtalènesulfonyle. 25 g de cette résine sont dissous dans 100 g de 5-méthyl- 2-hexanone. La couche de résine formée a une épaisseur de 1,7 micromètre. Après précuisson, elle est exposée aux rayons UV, à travers un masque, en appliquant une énergie de rayonnement de 85 mJ/cm², puis traitée pendant 10 minutes à 125°C avec des vapeurs d'hexaméthyldisilazane. Après développement, on obtient des motifs négatifs à haute résolution présentant des parois latérales verticales et ayant une épaisseur résiduelle de 1,6 micromètre, soit 94% de l'épaisseur initiale de la couche de résine déposée.

## Exemple 11.

On opère comme à l'exemple 1, mais en utilisant une résine photosensible préparée par estérification partielle du chlorure de 6-diazo-5,6-dihydro-5-oxo-1-naphtalènesulfonyle avec le produit de condensation d'octylphénol et de formaldéhyde. 30 g de cette résine sont dissous dans 100 g de cyclohexanone. La couche de résine formée a une épaisseur de 1,9 micromètre. Après précuisson à 95°C pendant 45 secondes sur une plaque chauffante, cette couche est exposée aux rayons UV, à travers un masque, en appliquant une énergie de rayonnement de 50 mJ/cm², puis traitée pendant 10 minutes à 125°C avec des vapeurs d'hexaméthyldisilazane. Après développement, on obtient des motifs négatifs à haute résolution présentant des parois latérales verticales et ayant une épaisseur résiduelle de 1,7 micromètre, soit environ 90% de l'épaisseur initiale de la couche de résine déposée.

## Exemple 12.

Cet exemple montre que la différentiation qui se produit entre les parties irradiées et les parties non irradiées de la résine photosensible lors de l'exposition de celle-ci à la lumière, est due essentiellement à une augmentation du taux de diffusion du composé de silicium dans les parties irradiées de la résine.

Cet exemple montre en même temps que le composé de silicium pénètre d'autant plus profondément dans ces parties irradiées que l'énergie du rayonnement UV appliquée est élevée.

Des tranches de silicium pourvues d'un oxyde thermique d'environ 120 nm d'épaisseur, sont traitées avec de l'hexaméthyldisilazane comme promoteur d'adhésion. En tant que résine photosensible, on utilise le produit d'estérification partielle du chlorure de 6-diazo-5,6-dihydro-5-oxo-1-naphtalènesulfonyle avec le produit de condensation de p-tert-butylphénol et de formaldéhyde. 25 g de cette résine sont dissous dans 100 g de cyclohexanone. La solution ainsi obtenue est enduite par centrifugation sur les tranches de silicium pour obtenir une couche de résine photosensible de 1,5 micromètre d'épaisseur.

Les tranches ainsi enduites sont précuites sur une plaque chauffante à 95°C pendant 45 secondes. Puis, on les soumet à un rayonnement ultraviolet en appliquant une énergie de rayonnement différente sur chaque échantillon. On obtient ainsi des échantillons qui ont été soumis à une énergie de rayonnement respectivement de 0, 13, 25, 38 et 50 mJ/cm². On traite ensuite les tranches ainsi exposées par des vapeurs d'hexaméthyldisilazane à 125°C pendant 10 minutes.

Les échantillons ainsi préparés sont soumis à la spectroscopie d'électrons AUGER. La pulvérisation ("sputtering" selon la terminologie anglo-saxonne) aux ions d'argon de la couche de résist à une vitesse de 3 nm/minute, permet d'obtenir la distribution en profondeur de la concentration relative de silicium dans la couche. A cet effet, l'intensité du pic de silicium, qui est proportionnelle à la concentration de silicium dans la couche de résist, est mesurée en fonction du temps de pulvérisation.

On constate que la concentration de silicium atteint une certaine valeur quelle que soit la quantité d'énergie appliquée. Après un certain temps de pulvérisation, l'intensité du pic de silicium décroît de manière abrupte et le pic finit par disparaître. Il s'est avéré que ce temps est manifestement fonction de l'énergie du rayonnement UV appliquée. C'est ainsi que, pour des énergies de rayonnement de 0, 13, 25, 38 et 50 mJ/cm², les pics de silicium disparaissent respectivement après environ 5, 20, 60, 110 et 160 minutes.

Par ailleurs, on prépare des échantillons similaires pour obtenir des motifs dans la couche en leur faisant subir le même traitement que ci-dessus et on les soumet à une opération de gravure par ions réactifs d'oxygène plutôt que de les soumettre à la spectroscopie AUGER. Il apparaît ainsi qu'une énergie de rayonnement comprise entre 13 et 25 mJ/cm² est suffisante pour fournir de bons motifs. Compte tenu de la vitesse de pulvérisation qui est de 3 nm/minute, on peut conclure qu'une profondeur de pénétration du composé de silicium dans la couche de résist d'environ 100 nm ralentit suffisamment la vitesse de gravure pour autoriser un dépouillement total des parties non irradiées. Ceci est en bonne correlation avec les épaisseurs résiduelles de 90 à 95% obtenues selon le procédé conforme à l'invention.

L'analyse par spectroscopie d'électrons AUGER montre donc que la diffusion du composé de silicium dans le résist est négligeable, voire insignifiante lorsqu'il n'est pas soumis à un rayonnement UV (énergie de rayonnement = 0). Cette analyse montre également qu'en augmentant la quantité d'énergie appliquée, le composé de silicium pénètre plus en profondeur dans la couche de résist, tandis que la concentration de silicium fixé est indépendante de la quantité d'énergie appliquée. Ce fait s'interprète le mieux en admettant que la transformation de la couche de résine sous l'effet de l'irradiation modifie sa perméabilité et rend possible la diffusion sélective du composé de silicium dans lesparties irradiées.

## Revendications

1. Procédé de formation de motifs négatifs dans une couche de photorésist, caractérisé en ce qu'il comprend les stades suivants:

(a) le recouvrement d'un substrat par une couche de résine photosensible comprenant un polymère contenant des groupes fonctionnels capables de réagir avec un composé de silicium, ledit polymère étant mélangé ou attaché par une liaison chimique à une diazoquinone, ladite couche ayant la propriété de permettre à un composé de silicium de diffuser sélectivement dans ses parties irradiées lorsqu'elle a été exposée à un rayonnement visible ou ultraviolet dans lesdites parties;

(b) l'exposition à de la lumière ultraviolette ou visible de la couche de résine photosensible à travers un masque, de façon à ce que seules les parties voulues de la couche soient exposées;

(c) le traitement de la couche de résine photosensible par un composé de silicium, de manière à ce que ce composé soit sélectivement absorbé dans les parties irradiées de la couche et entre en réaction avec lesdits groupes fonctionnels de la résine photosensible dans ces parties irradiées, ledit composé de silicium étant un agent de silylation; et

(d) le développement par voie sèche par gravure au plasma de la couche de résine photosensible ainsi traitée, de manière à enlever sélectivement les parties non irradiées de celle-ci pour obtenir les motifs négatifs souhaités.

2. Procédé selon la revendication 1, caractérisé en ce que la diazoquinone est choisie dans le groupe consistant en l'acide 5-diazo-5,6-dihydro-6-oxo-1-naphtalènesulfonique, l'acide 6-diazo-5,6-dihydro-5-oxo-1-naphtalènesulfonique, l'acide 3-diazo-3,4-dihydro-4-oxo-1-naphtalènesulfonique, l'acide 4-diazo-3,4-dihydro-3-oxo-1-naphtalènesulfonique, l'acide 3-diazo-3,4-dihydro-4-oxo-1-benzènesulfonique, les acides carboxyliques correspondants, leurs dérivés et les mélanges d'au moins deux des composés précités.

3. Procédé selon l'une quelconque des revendications 1 et 2, caractérisé en ce que le polymère est un polymère phénolique.

4. Procédé selon la revendication 3, caractérisé en ce que le polymère phénolique est choisi parmi

– les produits de condensation d'un phénol ou d'un naphtol, ou d'un dérivé de ceux-ci, substitué sur le noyau par un radical alkyle ou aryle ou par un atome d'halogène, avec un aldéhyde aliphatique ou aromatique, substitué ou non par un atome d'halogène,

– les poly(vinylphénols) dont le groupe phénolique est substitué ou non par un radical alkyle ou aryle ou un atome d'halogène,

– les copolymères d'un vinylphénol avec des composés éthyléniquement insaturés, et

– les mélanges des polymères précités entre eux ou avec d'autres polymères aromatiques.

5. Procédé selon l'une quelconque des revendications 1 à 4, caractérisé en ce que la résine photosensible comprend en outre un colorant.

6. Procédé selon l'une quelconque des revendications 1 à 5, caractérisé en ce que le composé de silicium est un agent de silylation facilement vaporisable.

7. Procédé selon l'une quelconque des revendications 1 à 6, caractérisé en ce que le composé de silicium est un agent de silylation choisi parmi le tétrachlorosilane, le triméthylchlorosilane, le diméthyldichlorosilane, le méthyltrichlorosilane, le triméthylbromosilane, le triméthlyiodosilane, le triphénylchlorosilane, l'hexaméthyldisilazane, l'heptaméthyldisilazane, l'hexaphényldisilazane, le 1,3-bis(chlorométhyl)-1,1,3,3-tétraméthyldisilazane, le N-triméthylsilylimidazole, le N-triméthylsilylacétamide, la N-triméthylsilyldiméthylamine, la N-triméthylsilyldiéthylamine, l'hexaméthylsilanediamine, le N,O-bis(triéthylsilyl)acétimide, la N,N'-bis(triméthylsilyl)urée, la N,N'-diphényl-N-(triméthylsilyl)urée et les mélanges d'au moins deux de ces composés.

8. Procédé selon la revendication 7, caractérisé en ce que l'agent de silylation est l'hexaméthyldisilazane.

9. Procédé selon l'une quelconque des revendications 1 à 8, caractérisé en ce que le traitement de la couche de résine photosensible par le composé de silicium est effectué à une température comprise entre –20 et 150°C.

10. Procédé selon la revendication 9, caractérisé en ce que le traitement de la couche de résine photosensible par le composé de silicium est effectué à une température comprise entre 60 et 140°C.

11. Procédé selon l'une quelconque des revendications 1 à 10, caractérisé en ce que la durée du traitement de la couche de résine photosensible par le composé de silicium est comprise entre quelques secondes et une heure.

12. Procédé selon la revendication 11, caractérisé en ce que la durée du traitement de la couche de résine photosensible par le composé de silicium est comprise entre 1 et 45 minutes.

13. Procédé selon l'une quelconque des revendications 1 à 12, caractérisé en ce que le développement par voie sèche est effectué par gravure au plasma d'oxygène ou par ions réactifs d'oxygène.

14. Utilisation du procédé selon l'une quelconque des revendications 1 à 13 pour la fabrication de circuits semi-conducteurs intégrés.

**Patentansprüche**

1. Verfahren zum Erzeugen von negativen Bildern in einer Photolackschicht, dadurch gekennzeichnet, daß es die folgenden Schritte umfaßt:

(a) Bedecken eines Substrates mit einer Schicht photoempfindlichen Harzes, umfassend ein Polymer, das funktionelle Gruppen, die zur Reaktion mit einer Siliciumverbindung fähig sind, enthält, wobei das Polymer mit einem Diazochinon vermischt oder mit diesem durch eine chemische Bindung verbunden ist, wobei diese Schicht die Eigenschaft aufweist, daß eine Siliciumverbindung selektiv in ihre bestrahlten Teile diffundieren kann, wenn sie einer sichtbaren oder ultravioletten Strahlung in diesen Teilen ausgesetzt wurde;

(b) Belichtung der Schicht photoempfindlichen Harzes mit ultraviolettem oder sichtbaren Licht durch eine Maske, so daß nur die gewünschten Teile der Schicht belichtet werden;

(c) Behandlung der Schicht photoempfindlichen Harzes mit einer Siliciumverbindung, derart, daß diese Verbindung selektiv in den bestrahlten Teilen der Schicht absorbiert wird und mit den funktionellen Gruppen des photoempfindlichen Harzes in den bestrahlten Teilen reagiert, wobei die Siliciumverbindung ein Silylierungsmittel ist; und

(d) Entwicklung auf trockenem Weg durch Plasmaätzen der so behandelten Schicht photoempfindlichen Harzes, derart, daß die nicht-bestrahlten Teile von dieser selektiv abgenommen werden, um die gewünschten negativen Bilder zu erhalten.

2. Verfahren nach Anspruch 1, dadurch gekennzeichnet, daß das Diazochinon ausgewählt ist aus der Gruppe bestehend aus 5-Diazo-5,6-dihydro-6-oxo-1-naphthalinsulfonsäure, 6-Diazo-5,6-dihydro-5-oxo-1-naphthalinsulfonsäure, 3-Diazo-3,4-dihydro-4-oxo-1-naphthalinsulfonsäure, 4-Diazo-3,4-dihydro-3-oxo-1-naphthalinsulfonsäure, 3-Diazo-3,4-dihydro-4-oxo-1-benzolsulfonsäure, den entsprechenden Carbonsäuren, ihren Derivaten und den Mischungen von wenigstens zwei der vorher genannten Verbindungen.

3. Verfahren nach einem der Ansprüche 1 und 2, dadurch gekennzeichnet, daß das Polymer ein Phenolpolymer ist.

4. Verfahren nach Anspruch 3, dadurch gekennzeichnet, daß das Phenolpolymer ausgewählt ist unter

– den Kondensationsprodukten eines Phenols oder eines Naphthols oder eines Derivates von diesen, das im Kern durch einen Alkyl- oder Arylrest oder durch ein Halogenatom substituiert ist, mit einem aliphatischen oder aromatischen Aldehyd, der durch ein Halogenatom substituiert sein kann,

– den Poly(vinylphenolen), deren Phenolgruppe durch einen Alkyl- oder Arylrest oder ein Halogenatom substituiert sein kann,

– den Copolymeren eines Vinylphenols mit äthylenisch-ungesättigten Verbindungen, und

– den Mischungen der vorher genannten Polymeren untereinander oder mit anderen aromatischen Polymeren.

5. Verfahren nach einem der Ansprüche 1 bis 4, dadurch gekennzeichnet, daß das photoempfindliche Harz außerdem einen Farbstoff enthält.

6. Verfahren nach einem der Ansprüche 1 bis 5, dadurch gekennzeichnet, daß die Siliciumverbindung ein leicht verdampfbares Silylierungsmittel ist.

7. Verfahren nach einem der Ansprüche 1 bis 6, dadurch gekennzeichnet, daß die Siliciumverbindung ein Silylierungsmittel ist, ausgewählt unter Tetrachlorsilan, Trimethylchlorsilan, Dimethyldichlorsilan, Methyltrichlorsilan, Trimethylbromsilan, Trimethyljodsilan, Triphenylchlorsilan, Hexamethyldisilazan, Heptamethyldisilazan, Hexaphenyldisilazan, 1,3-Bis(chlormethyl)-1,1,3,3-tetramethyldisilazan, N-Trimethylsilylimidazol, N-Trimethylsilylacetamid, N-Trimethylsilyldimethylamin, N-Trimethylsilyldiethylamin, Hexamethylsilandiamin, N,O-Bis(triethylsilyl)-acetimid, N,N'-Bis(trimethylsilyl)harnstoff, N,N'-Diphenyl-N-(trimethylsilyl)harnstoff und den Mischungen von wenigstens zwei dieser Verbindungen.

8. Verfahren nach Anspruch 7, dadurch gekennzeichnet, daß das Silylierungsmittel Hexamethyldisilazan ist.

9. Verfahren nach einem der Ansprüche 1 bis 8, dadurch gekennzeichnet, daß die Behandlung der Schicht photoempfindlichen Harzes mit der Siliciumverbindung bei einer Temperatur zwischen −20 und 150°C ausgeführt wird.

10. Verfahren nach Anspruch 9, dadurch gekennzeichnet, daß die Behandlung der Schicht photoempfindlichen Harzes mit der Siliciumverbindung bei einer Temperatur zwischen 60 und 140°C ausgeführt wird.

11. Verfahren nach einem der Ansprüche 1 bis 10, dadurch gekennzeichnet, daß die Behandlungsdauer der Schicht photoempfindlichen Harzes mit der Siliciumverbindung zwischen einigen Sekunden und einer Stunde beträgt.

12. Verfahren nach Anspruch 11, dadurch gekennzeichnet, daß die Behandlungsdauer der Schicht photoempfindlichen Harzes mit der Siliciumverbindung zwischen 1 und 45 Minuten beträgt.

13. Verfahren nach einem der Ansprüche 1 bis 12, dadurch gekennzeichnet, daß die Entwicklung auf trockenem Weg durch Sauerstoffplasmaätzen oder durch reaktives Sauerstoffionenätzen erfolgt.

14. Verwendung des Verfahrens nach einem der Ansprüche 1 bis 13 zur Herstellung von integrierten Halbleiterschaltkreisen.

## Claims

1. Process for the formation of negative patterns in a photoresist layer, characterised in that it comprises the following steps:

(a) coating of a substrate with a layer of photosensitive resin comprising a polymer having functional groups capable of reacting with a silicon compound, said polymer being mixed or bound by a chemical bound to a diazoquinone, said layer having the property of enabling a silicon compound to diffuse selectively into its irradiated portions when it has been exposed to a visible or ultraviolet radiation in said portions;

(b) exposure of the layer of photosensitive resin to ultraviolet or visible light through a mask to expose only selected portions of the layer;

(c) treatment of the layer of photosensitive resin with a silicon compound, so that this compound is selectively absorbed into the irradiated portions of the layer and reacts with the said functional groups of the photosensitive resin in said irradiated portions, said silicon compound being a silylating agent; and

(d) dry development by plasma etching of the thus treated layer of photosensitive resin to remove selectively the non-irradiated portions thereof in order to obtain the desired negative pattern.

2. Process according to claim 1, characterised in that the diazoquinone is selected from the group consisting of 5-diazo-5,6-dihydro-6-oxo-1-naphthalenesulfonic acid, 6-diazo-5,6-dihydro-5-oxo-1-naphthalenesulfonic acid, 3-diazo-3,4-dihydro-4-oxo-1-naphthalenesulfonic acid, 4-diazo-3,4-dihydro-3-oxo-1-naphthalenesulfonic acid, 3-diazo-3,4-dihydro-4-oxo-1-benzenesulfonic acid, the corresponding carboxylic acids, their derivatives and the mixtures of at least two of the aforesaid compounds.

3. Process according to any of claims 1 and 2, characterised in that the polymer is a phenolic polymer.

4. Process according to claim 3, characterised in that the phenolic polymer is selected from

— the condensation products of a phenol or a naphthol, or a derivative thereof ring-substituted by an alkyl or aryl radical or by a halogen atom, with an aliphatic or aromatic aldehyde, which can be substituted by a halogen atom,

— the poly(vinylphenols), the phenolic group of which can be substituted by an alkyl or an aryl radical or a halogen atom,

— the copolymers of a vinylphenol with ethylenically unsaturated compounds, and

— the mixtures of the aforesaid polymers between them or with other aromatic polymers.

5. Process according to any of claims 1 to 4, characterised in that the photosensitive resin further comprises a dye.

6. Process according to any of claims 1 to 5, characterised in that the silicon compound is an easily vaporizable silylating agent.

7. Process according to any of claims 1 to 6, characterised in that the silicon compound is a silylating agent selected from tetrachlorosilane, trimethylchlorosilane, dimethyldichlorosilane, methyltrichlorosilane, trimethylbromosilane, trimethyliodosilane, triphenylchlorosilane, hexamethyldisilazane, heptamethyldisilazane, hexaphenyldisilazane, 1,3-bis(chloromethyl)-1,1,3,3-tetramethyldisilazane, N-trimethylsilylimidazole, N-trimethylsilylacetamide, N-trimethylsilyldimethylamine, N-trimethylsilyldiethylamine, hexamethylsilanediamine, N,O-bis(triethylsilyl)acetimide, N,N'-bis(trimethylsilyl)urea, N,N'-diphenyl-N-(trimethylsilyl)urea and the mixtures of at least two of these compounds.

8. Process according to claim 7, characterised in that the silylating agent is hexamethyldisilazane.

9. Process according to any of claims 1 to 8, characterised in that the treatment of the layer of photosensitive resin with the silicon compound is carried out at a temperature between −20 and 150°C.

10. Process according to claim 9, characterised in that the treatment of the layer of photosensitive resin with the silicon compound is carried out at a temperature between 60 and 140°C.

11. Process according to any of claims 1 to 10, characterised in that the time of the treatment of the layer of photosensitive resin with the silicon compound is between a few seconds and one hour.

12. Process according to claim 11, characterised in that the time of the treatment of the layer of photosensitive resin with the silicon compound is between 1 and 45 minutes.

13. Process according to any of claims 1 to 12, characterised in that the dry development is carried out by oxygen reactive ion or oxygen plasma etching.

14. Use of the process according to any one of claims 1 to 13 for the manufacture of integrated semiconductor circuits.

Fig. 1

Fig. 2

Fig. 3

Fig. 4